# EUROPEAN PATENT APPLICATION

(11) **EP 1 942 301 A2**
(43) Date of publication of application: **09.07.2008**
(21) Application number: 08005977.7
(22) Date of filing: 18.10.2005
(51) Int. Cl.: F21S 4/00, H05K 1/18, H01L 25/075

(54) **Microelectronics package and method**

(30) Priority: 18.10.2004 US 619722 P
(62) Divisional of application: 05812562.6
(71) Applicant: AgiLight, Inc., San Angelo, TX 76905 (US)
(72) Inventor: Gregory, John, Atlanta GA 30350 (US)
(74) Representative: South, Nicholas Geoffrey

(57) **Abstract**

A lightwire segment in the form of an elongated substrate frame composed of a flat flexible thin elongated sheet of plastic dielectric material having a copper film laminated on at least one side; a plurality of cavities longitudinally spaced along the elongated substrate, a LED diode having first and second contacts embedded in each of the cavities of the substrate; the copper film on one side of the substrate defining two interconnects separated by a dielectric space, one interconnect having a tab bonded to the first contact of each LED diode, and the other interconnect having a tab bonded to the second contact of each LED diode. A lightwire made from a plurality of segments that are bonded together in series or parallel. A micropackage made from a substrate frame composed of a flat flexible thin sheet of plastic dielectric material having a copper film laminated on one side defining rows and columns of component sites separated from one another by thin webs to be readily detached from the substrate frame. The micropackage has indexing elements to position the substrate frame relative to a machine that can pick the component sites out of the frame. Each component site defines a cavity formed in the substrate, and the copper film laminated on the substrate defines two separated interconnects, each having a tab extending into the cavity formed in the substrate. An electrical component having contacts is positioned in the cavity and its contacts are bonded to the tabs.

## Description

### BACKGROUND OF THE INVENTION

### Field of the invention

The invention relates to a method for micropackaging small chips and other electrical components and the resulting micropackage. More particularly, the invention relates to a method for micropackaging small chips and other electrical components and forming a lightwire, wherein LED diodes are embedded in a flexible plastic substrate and further relates to a micropackage that has an array of LED diodes embedded in an elongated flexible plastic substrate.

### Prior Art

Various techniques have been proposed for packaging microelectronics and electrical devices, but none offer a planarized package, or the capability to make small and flat packages, such that mass production can take place more effectively, and the resulting products are reduced in size and weight. In the past, LED diodes have been package by surface mounting the dies or chips using wire bonding or flip chip technology. Since the LED component is a rigid chip, if surface mounted on a flexible substrate, there is a danger that the component or one or more of the connections to the flexible substrate will pop-off or disconnect when the substrate is flexed.

### SUMMARY OF THE INVENTION

The present invention provides a method of packaging microelectronic devices, such as silicon chips and electrical components, in a way that produces flat small and lightweight packages. Accordingly, the principal object of the present invention is to provide a method and device that solves the above disadvantage of the prior art. Therefore the present invention provides a method for micropackaging LED diodes on a flexible substrate, and micropackages including a flexible substrate that will not suffer the disadvantages of the prior art and pop-off or lose connections when the substrate is flexed.

The above is achieved by a novel method for micropackaging that embeds an electrical or electro mechanical device in a flexible plastic substrate, and by a micropackage that has the device embedded in a flexible plastic substrate.

The embedding of the device or component in the flexible substrate will enhance the procedure for making lightwires that are planar and small and thin.

This is accomplished by the present invention by a method that comprises making a lightwire comprising the steps of: making a lightwire segment by providing an elongated substrate frame composed of a flat flexible thin elongated sheet of plastic dielectric material having a copper film laminated on at least one side; forming a series of cavities longitudinally spaced along the elongated substrate; positioning LED diodes having first and second contacts embedded in the cavities of the substrate; processing the copper film on one side of the substrate to define two interconnects separated by a dielectric space with first and second tabs protruding into the cavities; bonding the first tabs to the first contacts of said LED diodes; and bonding the second tabs to the second contacts of said LED diodes. A plurality of lightwire segments made according to the above can be interconnected in series or in parallel.

Also, the invention contemplates a micropackage comprising a substrate frame composed of a flat flexible thin sheet of plastic dielectric material having a copper film laminated on one side; said copper film on said one side of the substrate defining rows and columns of component sites separated from one another by thin webs whereby the sites can be readily detached from the substrate frame.

The micropackage above can have the substrate frame provided with indexing elements to position the substrate frame relative to a machine that can pick the component sites out of the frame. Each component site can define a cavity formed in the substrate, and the copper film laminated on the substrate can define two separated interconnects, each having a tab extending into the cavity formed in the substrate. An electrical component having contacts can be positioned in the cavity and its contacts are bonded to the tabs.

The invention further contemplates a lightwire segment comprising an elongated substrate frame composed of a flat flexible thin elongated sheet of plastic dielectric material having a copper film laminated on at least one side; a series of cavities longitudinally spaced along the elongated substrate, a LED diode having first and second contacts embedded in each of the cavities of the substrate; the copper film on one side of the substrate defining two interconnects separated by a dielectric space, one interconnect having a tab bonded to the first contact of each LED diode, and the other interconnect having a tab bonded to the second contact of each LED diode. The lightwire according to the above can have a termination defining terminals coupled to one end of the lightwire. A structure comprising at least two lightwire segments according to the above are coupled together in series or parallel, is also a contemplated structure.

Other and further advantages of the present invention will become apparent from the following detailed description when taken in conjunction with the appended drawings.

### BRIEF DESCRIPTION OF THE DRAWINGS

Fig. 1A is a schematic showing of a flat panel in which has been embedded diodes, such as LED diodes or photo diodes;
Fig. 1B is a schematic showing a similar panel as shown in Fig. 1A, but a larger number of sites;
Figs. 2A to 2E show schematically the mounting of an axial diode according to the present invention;
Figs. 3A to 3F show schematically the mounting of a linear diode according to the present invention;
Figs. 4A to 4D show schematically a light wire strip;
Figs. 5A to 5C show schematically how light wire strips are connected together;
Figs. 6a to 6F show schematically further details of the light wire construction;
Figs. 7A and 7B show schematically the terminal end of a light wire strip;
Figs. 8A to 8E show schematically the termination of a light wire strip with a connector; and
Figs. 9A to 9E show further details of the light wire structure according to the present invention.

### DETAILED DESCRIPTION OF PREFERRED EMBODIMENTS OF THE

### INVENTION

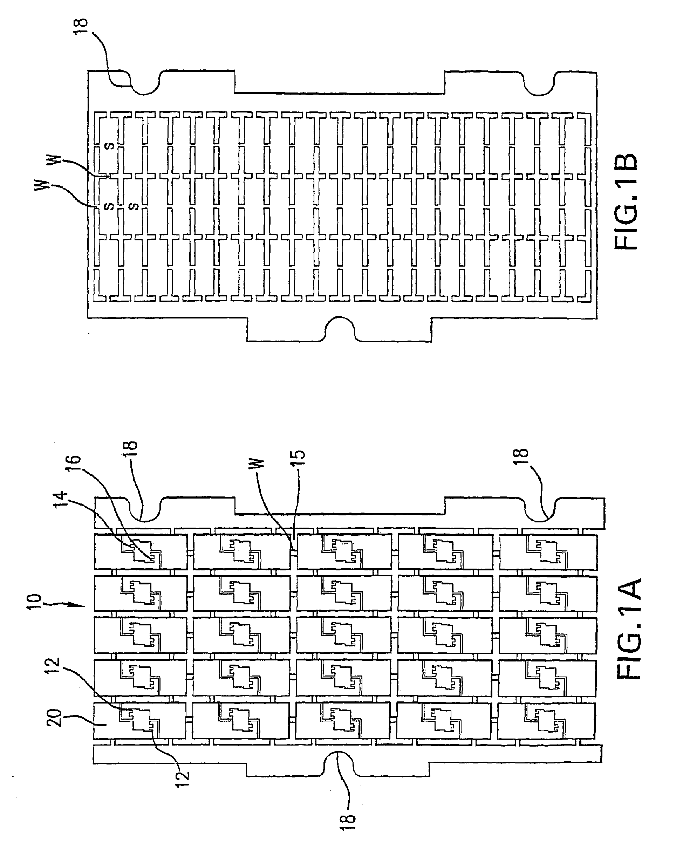

Unique packaging of microelectronic components is shown in Figs. 1A and 1B.

There is shown a flat panel 10 composed of plastic with copper films top and bottom. By known photo imaging and lithographic processing the copper films are removed in selected areas to reveal a plurality of bare plastic areas on one side and configured on the other side, shown in Fig. 1A, the copper film is formed into two electrodes 12 per site 20 and two contacts 14 per site to be bonded with diodes 16 positioned in the sites, as shown in US Patent No. 6956182 issued October 18, 2005 to the same inventor, said patent being incorporated herein by reference in its entirety. The sites 20 are defined by cutouts 15 punched in the substrate leaving webs W. The panel 10 is provided with indexing cutouts 18 for positioning in a pick and place machine. The diodes can be of any type, e.g. LED diodes, photo diodes or other types. The arrangement of a micropackage, comprising an array of sites as shown in Figs. 1 A and 1B, can be used for any microelectronic component, such as, a chip. Also, the electronic components can comprise a mixture of different ones.

Fig. 1B shows a panel similar to the one shown in Fig. 1A, but with a larger number of sites with dimensions in millimeters marked on Fig. 1B to show the small size of the product, the sites S are defined by cutouts 15 punched in the substrate leaving webs W to facilitate removal by a pick and place apparatus.

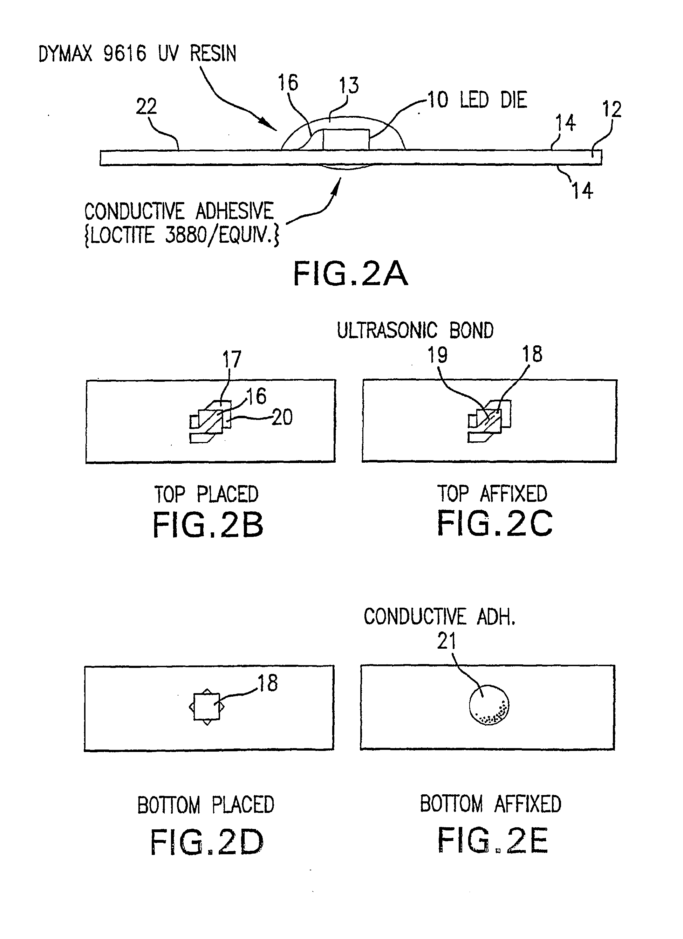

The method of the present invention, as shown in Figs. 2A to 2E, consists of providing an interconnect for an LED die to a flexible substrate that could serve as an interposer to connect the LED die mounted on the first flexible substrate to a second flexible substrate. The mounting of the LED die to a flexible substrate is achieved by ultrasonically bonding a circuit interconnect to the LED die by employing a method of embedding the LED die in a substrate as described in US Patent No. 6956182 issued October 18, 2005, the contents of which are herein incorporated by reference in their entirety. This method consists essentially of providing a flexible, dielectric substrate laminated with a conductive foil, preferably copper, on opposite sides of the substrate. First, an interconnecting conductive circuit is created on the top side of the laminated dielectric substrate by selectively removing portions of the conductive foil using known photo-imaging techniques to leave remaining an interconnecting conductive circuit projecting in part (one tab if an axial LED die is to be mounted, and two tabs if a linear LED die is to be mounted) into the perimeter of a preselected volume of the dielectric substrate material. Then, using photo-imaging techniques, the conductive foil from the bottom side of the laminated dielectric substrate is photo-imaged and removed within the perimeter of the preselected volume to expose the dielectric substrate material within the said perimeter. Thus, there are two tabs on the top side for a linear LED die mounting, and one tab on the top side projecting into the cavity to be formed for an axial LED die mounting. Next, the volume of the dielectric substrate material within said perimeter is removed by laser ablation to create a cavity or void in the dielectric substrate material without destroying the parts of the interconnecting conductive circuit projecting into the perimeter of the void. Then, an electronic component (e.g. LED die) is inserted into the void, preferably, having a thickness not greater than the preselected thickness of the laminated dielectric substrate (axial LED dies) tend to be thicker than the substrate and therefore, will project). At least one contact will correspond in position to the part (tab) of said interconnecting conductive circuit that project into the perimeter of the void so that when fully inserted, the contact on the electronic component registers with and contacts said projecting part (tab) of the interconnecting conductive circuit. As noted, for a linear LED die, there will be two tabs projecting into the cavity or void. Finally, the contact(s) on the electronic component (e.g. LED die) and the projecting part(s) of the interconnecting conductive circuit on the top side is (are) bonded together (preferably by ultrasonic bonding) to hold the electronic component in the cavity or void of the dielectric substrate material. In the case of an axial LED die, a material, e.g. Ag solder, is applied to the bottom side of the substrate to fixed and provide an electrical contact to the bottom of the axial LED die to the bottom conductive film of the substrate.

Figs. 2A to 2E illustrate a mounting of an axial LED die 10 to a substrate 12, with the mounting manufactured in the above-described manner which results in an electrical connection on the top side which is 18 microns in thickness. As shown, a flexible substrate 12 composed of a dielectric material, such as, PET or LCP or other suitable dielectric plastic material, with copper films 14 laminated on the top and bottom sides, has embedded therein (in a cavity or void 17) a LED diode 10 interconnected by top tab 16, formed from the copper film 14 laminated on the top side. The tab 16 on the top surface is ultrasonically bonded at 19 to the top contact 18 on the LED diode 10. The bottom contact 18 of the LED die 10 is fixed by a Ag solder 21 that connects the bottom of the LED die 10 with the copper film 14 laminated to the bottom of the substrate. A doming transparent epoxy 13, such as DYMAX 9616, made by the Dymax Corporation of Torrington, CT, covers the LED die 10

Whereas the cavity 17 created by laser ablation has to be at least the complementary size and shape of the chip 10, it is preferably made slightly larger (see reference numeral 20) than the chip 10 to provide a small relief 23 at the sides. The tab 16 is part of the interconnect circuit 22 which is the power side of the LED die. The bottom film 14 serves as the ground. The top and bottom copper films can be from 12 to 20 microns thick. Preferably the films 14 are composed of ½ oz copper and about 18 microns thick. If the arrangement is to form an interposer, the copper films 14 can extend out over the ends of the dielectric substrate 12 to form flanges, which flanges can be bonded (e.g. ultrasonic bonding or soldering) to contacts or connections of an electrical circuit on a PCB or other second substrate that the interposer is mounted to. The circuit contacts or connections on the PCB or other substrate are preferably copper.

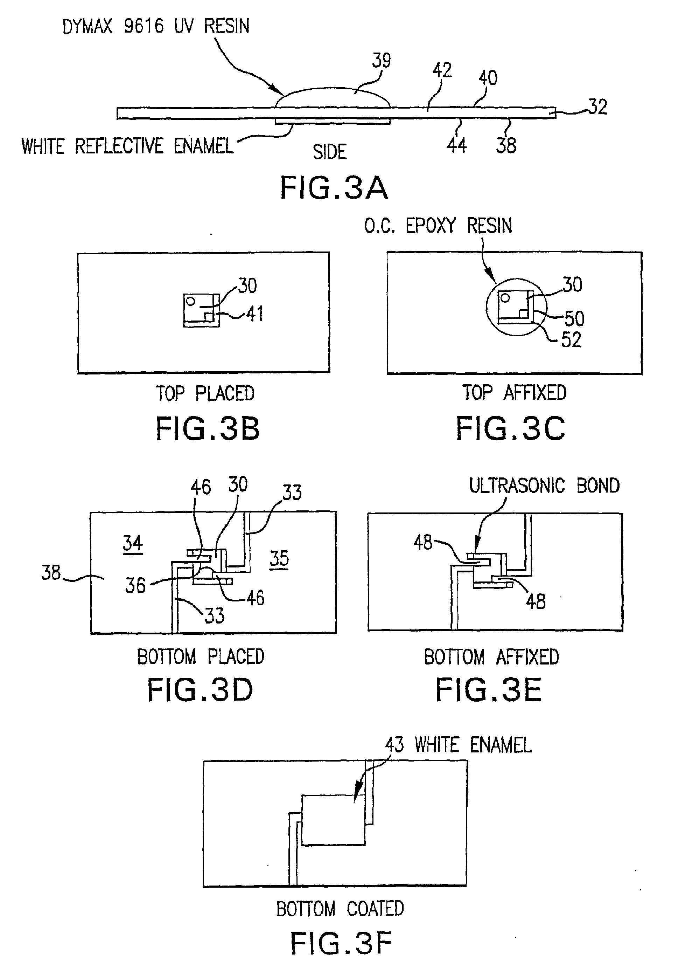

Figs. 3A to F illustrate a mounting of a linear LED die 30 to a substrate 32 in a cavity or void, with the mounting manufactured in the above-described manner which results in electrical interconnects 34, 35, formed in the bottom film 38, which is 18 microns in thickness, to the contacts 36 of the linear LED die 30 on the bottom side 38, the chip being inserted, contact side down into the cavity from the top. The interconnects 34, 35 (interconnect 34 serves as the power connect, and interconnect 35 serves as the ground connect) are separated by two channels 33 by photo-imaging so that exposed dielectric material of the substrate 32 separates them. The top side film 40, also 18 microns thick, can serve as a ground plane as will be explained hereinafter. As shown, a flexible substrate 32 composed of a dielectric material, such as, PET or LCP or other suitable dielectric plastic material, with copper films 40, 38 laminated on the top and bottom sides 42, 44, has embedded therein, in a cavity or void 41, a linear LED die 30 interconnected by tabs 46, formed from the copper film 38 laminated on the bottom side 44. The two tabs 46 on the bottom side of the substrate, one projecting from each interconnect are ultrasonically bonded at 48 to the contacts 36 on the LED die 30. The LED die will emanate light from both the top and the bottom. The bottom of the LED die 30 is coated with a white reflective enamel coating 43 to reflect the light through the top and to provide a continuous surface with the copper film 38 laminated to the bottom of the substrate 32. A transparent doming epoxy 39, as described above, is placed on the top film 40 over the chip 30 and has a diameter substantially greater than the width of the chip to spread out the light emanating from the chip. If desired, a similar doming can be placed on the bottom of the substrate instead of the reflective white enamel, if it is desired to emanate light out both the top and the bottom.

Whereas the cavity or void 41 created by laser ablation has to be at least the complementary size and shape of the chip 30, it is preferably made slightly larger (see reference numeral 50) than the chip 30 by about 12 microns on two adjacent sides and is provided with small relief recesses 52 at the corners. Interconnect 35 can be connected by vias to the top film 40 to serve as a ground plane. The vias can be drilled, lasered or punched holes that are filled with either copper or conductive ink to electrically couple the interconnect 35 to top film 40.

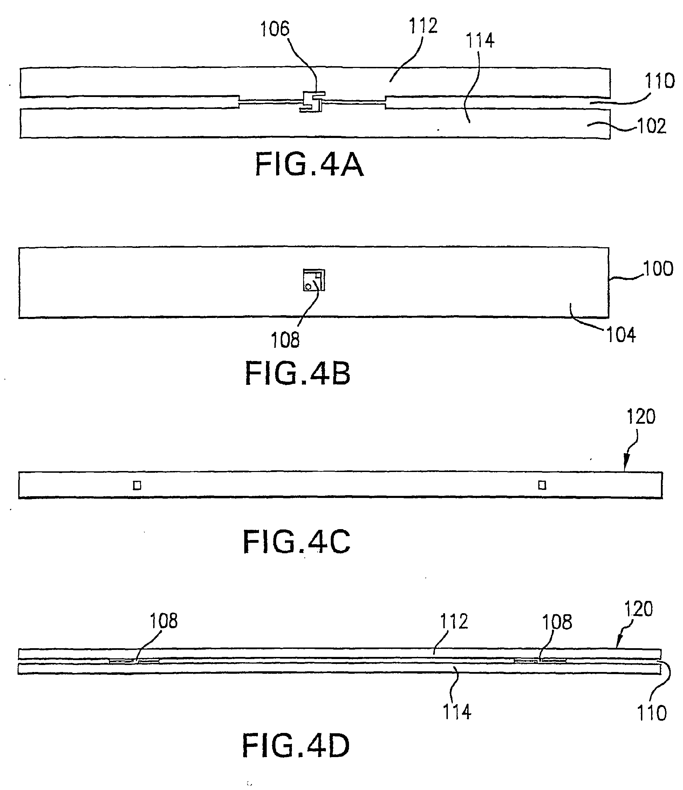

Referring now to Figs. 4A to 4D, a lightwire is shown according to the present invention. Fig. 4A shows the top of the basic construction and Fig. 4B shows the bottom of the basic construction. As shown, a substrate 100 having a copper film, as described, laminated to top 102 and bottom 104. A cavity 106 is laser ablated in the substrate in the manner described, and a linear LED die 108 is ultrasonically bonded in the cavity, in the manner described. In the processing, a separation or gap 110 is formed between the circuit connections 112 (for the positive or anode) and 114 (for the ground or cathode), by removal of the copper film, leaving the plastic dielectric substrate exposed. Figs. 4C and 4D show the lightwire 120, with Fig. 4C showing the bottom and Fig. 4D the top; two diodes are shown, but normally, the lightwire will hold about 15 diodes separated as shown in Figs. 4C and 4D. Dimensions have been marked on the figures to give an idea of size.

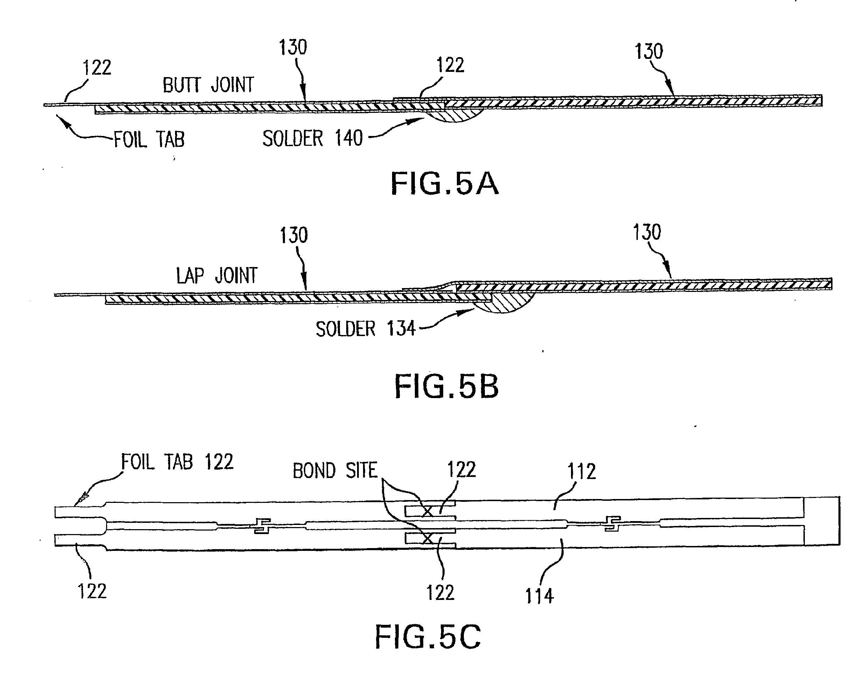

Figs. 5A and 5B show the manner for connecting lightwire segments 130. Fig. 5A shows a butt joint wherein the foil tabs 122 of one lightwire segment 130, extending from the substrate 100, are overlapped on the next adjacent lightwire segment 130 and ultrasonically bonded to the interconnects 112 and 114 of the next adjacent lightwire segment 130. Accordingly, the interconnects 112 and 114 are electrically coupled on successive and adjacent lightwire segments. The bottom films are soldered together as indicated at 140. In this fashion, the lightwire segments 130 can be coupled together for whatever length is desired with electrical integrity. Fig. 5C shows a top view of the butt joint described. Fig. 5B shows forming a lap joint between adjacent lightwire segments 130. This is accomplished by removing the end portion of the top interconnects, as indicated at 132, so that the bottom will not contact copper film on the top, and then connecting by soldering at 134, as shown, so that bottom to bottom is connected electrically. The top is electrically connected by tabs or strips 136 to connect electrically successive interconnects 112 and 114, respectively.

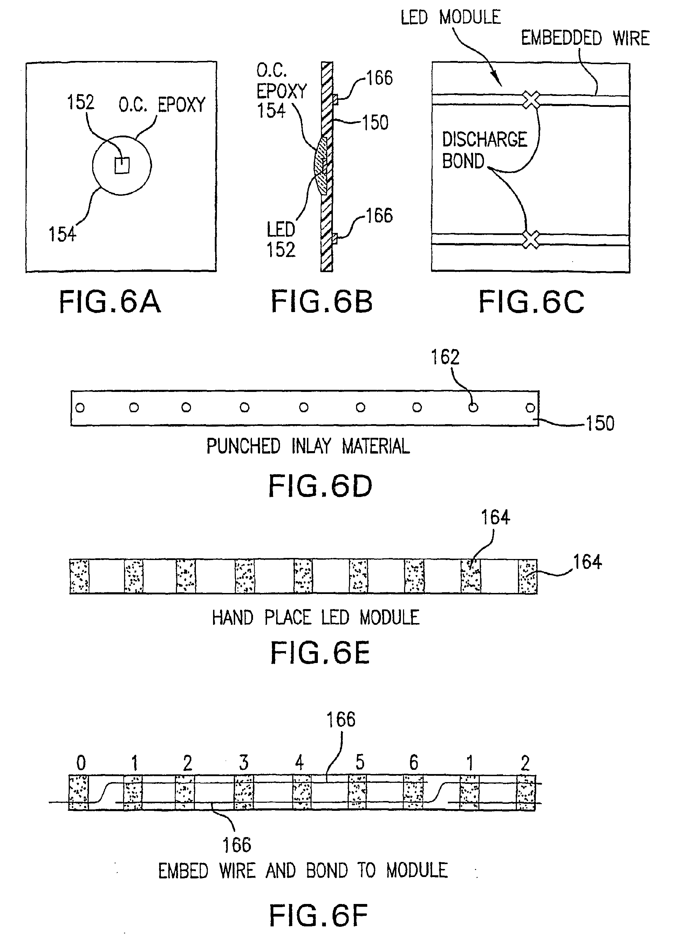

Figs. 6A to 6E show another method for making a lightwire segment. As shown in Figs. 6A to 6C, a portion of a substrate 150 that has imbedded therein a linear LED diode 152, in the way already described, with doming 154, as described, with separate interconnects to the two contacts on the diode. As shown in Fig. 6D, a substrate 150 is punched with holes 162, LED diode modules 164 are placed in the holes 162 and fixed to the substrate 150. Wires or ribbons 166 are embedded in the substrates and connected to the interconnects 112 and 114 of the modules as shown in Fig. 6C by bonding. In this manner, the interconnects 112 and 114 of all modules 164 are interconnected electrically together, respectively.

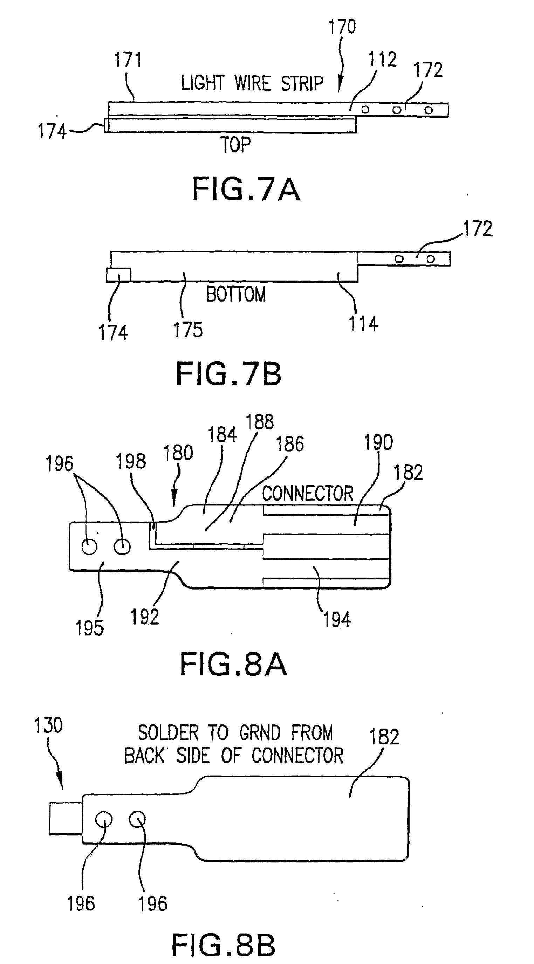

Fig. 7 shows a lightwire segment 170 having a foil flange 172 extending from the top 171 on the positive interconnect 112, and a foil flange 174 extending from the ground interconnect 114 at the other end, which has been folded over and bonded to the copper film 175 on the bottom.

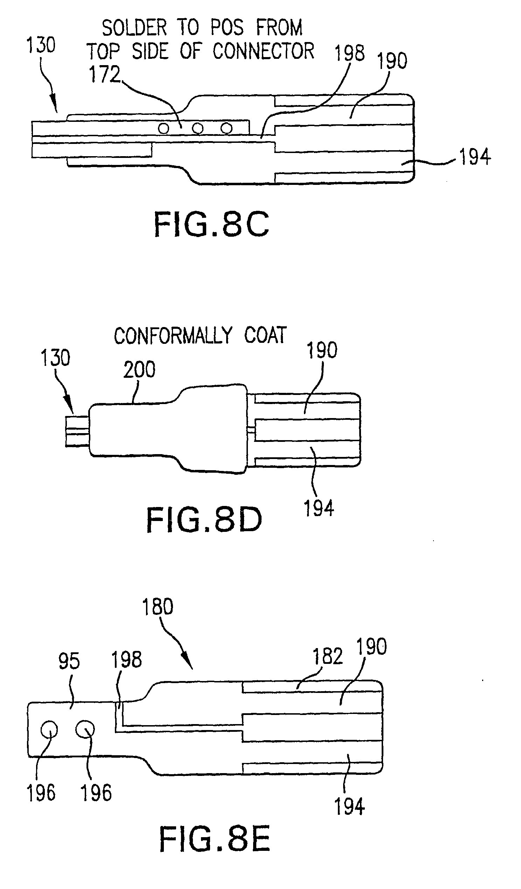

Figs. 8A to 8E show the terminal or connector 180 used to terminate a lightwire segment or series of lightwire segments. The terminal consists of a main body 182 of plastic or other suitable dielectric material, having coated or laminated thereon copper film 184. Film 184 is photo-imaged to define a positive terminal 186 having a connection section 188 and a terminal for connection 190 that extends to the front end of body 180. The ground connection is defined by copper film 184 as a ground terminal 192 having a connection section 195 at the rear of body 182 and a terminal for connection 194 that extends parallel to terminal 190 and goes to the front end of the body 182. Two holes 196 are formed in section 194. A gap 198 separates the positive side from the ground side. The connection of the lightwire segment 130 is as follows. The lightwire segment 130 is placed on the terminal 180 so that the foil flange 172 overlies the connection section 188 of the positive side and the bottom of the segment 130 is contacting the section 194 on the ground side. Foil flange 172 is soldered or bonded ultrasonically to the connection section 188 of the positive side. The back of segment is soldered to section 194 on the ground side via the holes 196 as shown in Figs. 8A to 8C. Finally, a conformal coating 200 is placed over the terminal 180 to cover the bonding and soldering, see Fig. 8D. Fig. 8E shows the terminal 180 in larger view with dimensions to give an idea of size.

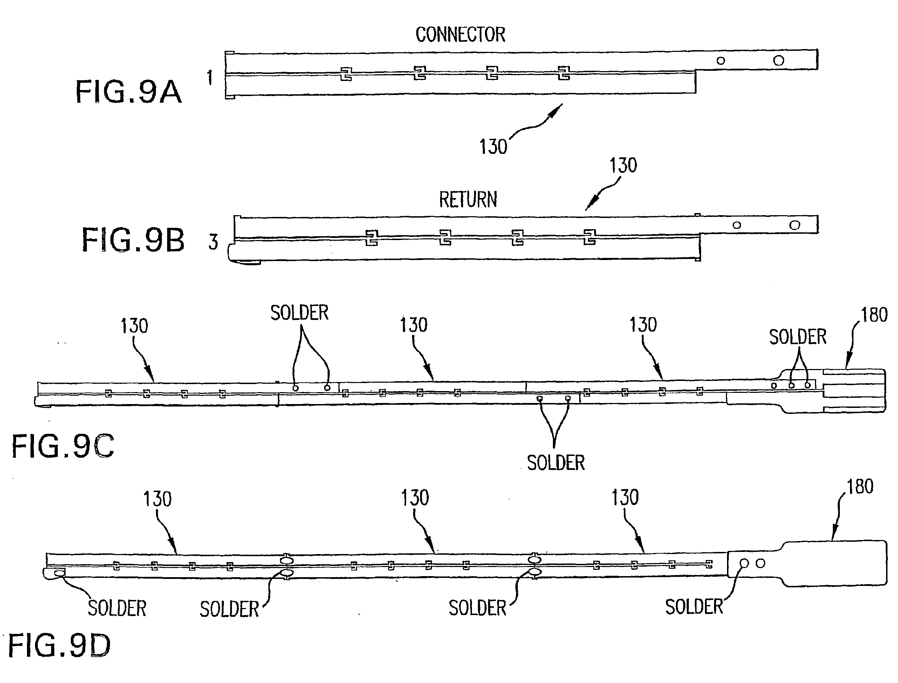

Referring now to Figs. 9A to 9D, further views of a series of lightwire segments bonded together are shown. Also, the addition of the terminal 180 is added in Figs. 9C and 9D. The same reference numerals have been used, and the description of these views will be readily understood from the foregoing. Although the invention has been shown and described in specific preferred embodiments, nevertheless changes and modifications are possible without departing from the invention as claimed. Such changes and modifications as are evident to one skilled in the art are deemed to fall within the purview of the invention as claimed.

## Claims

1. A lightwire segment comprising an elongated substrate frame composed of a flat flexible thin elongated sheet of plastic dielectric material having a copper film laminated on at least one side; a series of cavities longitudinally spaced along the elongated substrate, a LED diode having first and second contacts embedded in each of the cavities of the substrate; the copper film on one side of the substrate defining two interconnects separated by a dielectric space, one interconnect having a tab bonded to the first contact of each LED diode, and the other interconnect having a tab bonded to the second contact of each LED diode.

2. A lightwire according to claim 1 wherein a termination defining terminals is coupled to one end of the lightwire.

3. A structure comprising at least two lightwire segments according to claim 1 which are coupled together in series or parallel.

4. A method of making a lightwire comprising the steps of: making a lightwire segment by providing an elongated substrate frame composed of a flat flexible thin elongated sheet of plastic dielectric material having a copper film laminated on at least one side; forming a series of cavities longitudinally spaced along the elongated substrate; positioning LED diodes having first and second contacts embedded in the cavities of the substrate; processing the copper film on one side of the substrate to define two interconnects separated by a dielectric space with first and second tabs protruding into the cavities; bonding the first tabs to the first contacts of said LED diodes; and bonding the second tabs to the second contacts of said LED diodes.

5. A method of making a lightwire comprising the further step of interconnecting a plurality of lightwire segments made according to claim 4 in series or in parallel.
